# EUROPEAN PATENT SPECIFICATION

(11) **EP 4 243 190 B1**
(45) Date of publication and mention of the grant of the patent: **23.04.2025**
(21) Application number: 23156000.4
(22) Date of filing: 10.02.2023
(51) Int. Cl.: H01M 50/519, H01M 50/507, H01M 50/538, H01M 50/569

(54) **BATTERY CONNECTION MODULE**
BATTERIEANSCHLUSSMODUL
MODULE DE CONNEXION DE BATTERIE

(30) Priority: 25.02.2022 CN 202210176861
(43) Date of publication of application: 13.09.2023
(73) Proprietor: Molex, LLC, Lisle, IL 60532 (US)
(72) Inventor: ZENG, Shang Xiu, ChengDu (CN); LIM, Kian Heng, Jurong Town (SG); GOH, Siow Pheng, Jurong Town (SG)
(74) Representative: Ter Meer Steinmeister & Partner

(56) References cited:
- EP-A1- 3 836 285
- US-A1- 2019 027 731
- US-A1- 2020 365 866
- US-A1- 2022 013 867

## Description

### TECHNICAL FIELD

The present disclosure relates to the field of battery technology, and specifically relates to a battery connection module.

### BACKGROUND

EP 3 836 285 A1 discloses a battery module. The battery module includes a cell stack formed by stacking a plurality of battery cells; a bus bar frame assembly including a bus bar frame configured to cover one longitudinal end and the other longitudinal end of the cell stack and a plurality of bus bars fixed on the bus bar frame and electrically connected to the battery cells; and a FPCB assembly. The FPCB assembly includes a first FPCB extending along a longitudinal direction of the cell stack to cover at least a portion of an upper surface of the cell stack, a second FPCB extending from one longitudinal end of the first FPCB and electrically connected to the bus bars, and a connector having a connector pin inserted into a pin insert hole formed in the second FPCB.

US 2022/013867 A1 discloses a connection module. The connection module is mounted on a power storage element group including power storage elements having electrode terminals and connecting the power storage elements. The connection module includes a FPC including wiring portions and bus bars connected to the wiring portions and connecting the electrode terminals of the power storage elements that are adjacent to each other. The FPC includes a first multi-layered portion including the wiring portions that are overlapped with each other by folding the FPC and includes a second multi-layered portion including the wiring portions that are overlapped with each other by folding the FPC.

US 5,130,499 discloses a flexible circuit board, the flexible circuit board is formed by folding at least two partial main strips which run next to and at a distance from each other and which are connected to each other at adjacent ends by a main connecting strip, the main connecting strip is folded double so that one partial main strip is folded until it is in line with the other. If a length of a main body of the flexible circuit board is very long, manufacturing difficulty will be significantly promoted, and cost is high. The prior art provides a folding construction which folds the main body to increase the length, production difficulty may be greatly lowered and utilization ratio of a material promoted.

However, the prior art provides a solution which only directs folding of the straight line type flexible circuit board. In another circumstance, in addition to straightly extend, a flexible circuit board further turns toward a plane different from a plane in which the flexible circuit board straightly extends, and in a circumstance that needs to provide a wire jumper to realize different output circuit definitions, the prior art does not disclose or teach how to promote utilization ratio of a material, realize a construction of the wire jumper and lower cost.

### SUMMARY

Therefore, an object of the present disclosure is to provide a battery connection module which can improve at least one deficiency of the prior art.

The object is solved by the features of the independent claims Preferred embodiments are given in the dependent claims.

A battery connection module of an embodiment of the present disclosure is used to connect a battery unit array, the battery connection module comprises a plurality of busbars and a plurality of sampling assemblies, the plurality of busbars are used to connect the battery unit array, each sampling assembly comprises a first flexible circuit board, an adapting circuit board and a second flexible circuit board, the first flexible circuit board connects the plurality of busbars, the first flexible circuit board is constituted by folding at least two sub flexible circuit boards, a rear end of the first flexible circuit board comprises a turning portion, the turning portion is connected to the adapting circuit board which is positioned in a plane different from a plane where the first flexible circuit board is presented, a front end of the second flexible circuit board is connected to the adapting circuit board, a rear end of the second flexible circuit board comprises at least one electrical connector.

The adapting circuit board has a wire jumper construction.

According to one or more embodiments, a wiring arrangement definition of the first flexible circuit board may be different from a wiring arrangement definition of the second flexible circuit board.

According to one or more embodiments of the present disclosure, the first flexible circuit board and the second flexible circuit board each may be a single layer wiring board.

According to one or more embodiments, the adapting circuit board may be a double layer wiring board.

According to one or more embodiments of the present disclosure, the adapting circuit board may be a rigid circuit board.

According to one or more embodiments of the present disclosure, each first flexible circuit board may have the same construction.

According to one or more embodiments of the present disclosure, each second flexible circuit board may have a different length.

According to one or more embodiments, the lengths of the plurality of second flexible circuit boards may be set so that the respective electrical connectors of the rear ends of the respective second flexible circuit boards may be close to be compactly arranged.

According to one or more embodiments of the present disclosure, the first flexible circuit board may comprise the at least two sub flexible circuit boards which are integrally constructed and a folding portion/folding portions which each connect end portions of respective sub flexible circuit board.

According to one or more embodiments, each folding portion may comprise a folding close line and a folding away line.

According to one or more embodiments of the present disclosure, each sub flexible circuit board may comprise at least one wiring track, from a front end of the first flexible circuit board to the rear end of the first flexible circuit board, latter one the sub flexible circuit board may be more than former one the sub flexible circuit board by one wiring track.

According to one or more embodiments of the present disclosure, the first flexible circuit board may be provided at a top surface of the battery unit array.

According to one or more embodiments, the adapting circuit board and the second flexible circuit board may be provided at a side surface of the battery unit array.

One embodiment of the present disclosure at least has following advantages or beneficial effects. The first flexible circuit board performs folding by means of a plurality of sub flexible circuit boards, a length of the first flexible circuit board is increased in the process of folding away from each other, production difficulty may be greatly lowered and utilization ratio of a material is promoted. That the first flexible circuit board and the second flexible circuit board are adapted by the adapting circuit board may realized a layout of the first flexible circuit board and the second flexible circuit board in different planes, and that the first flexible circuit board and the second flexible circuit board may be each separately manufactured promotes utilization ratios of materials.

### BRIEF DESCRIPTION OF THE DRAWINGS

FIG. 1 illustrates a schematic view of a battery connection module of a first embodiment of the present disclosure mounted over a battery unit array.
FIG. 2 illustrates a partially enlarged view indicated by a dotted line frame A of FIG. 1.
FIG. 3 illustrates a partially enlarged view indicated by a dotted line frame B of FIG. 1.
FIG. 4 illustrates a schematic view a plurality of sampling assemblies of FIG. 1 with the battery unit array removed.
FIG. 5 illustrates a schematic view of one of the plurality of sampling assemblies of the first embodiment of the present disclosure.
FIG. 6 illustrates an exploded schematic view of FIG. 5.
FIG. 7 illustrates a partially enlarged view indicated by a dotted line frame C of FIG. 6.
FIG. 8 illustrates a partially enlarged view indicated by a dotted line frame D of FIG. 6.
FIG. 9 illustrates a schematic view that a first flexible circuit board of the disclosure is not folded.
FIG. 10 illustrates a schematic view that local parts of a second flexible circuit board of the present disclosure partially are not folded.
FIG. 11 illustrates an exploded schematic view of FIG. 8.
FIG. 12 illustrates a partially exploded schematic view of a sampling assembly of a second embodiment of the present disclosure.
FIG. 13 illustrates a schematic view a sampling assembly of a third embodiment of the disclosure.
FIG. 14 illustrates a schematic view that a first flexible circuit board of FIG. 13 is not fold.

### Reference numerals are presented as follows:

| | | | |
|---|---|---|---|
| 100 | battery connection module | 215 | folding away line |
| 200 | battery unit array | 216 | wiring track |
| 1 | busbar | 22 | adapting circuit board |
| 2 | sampling assembly | 23 | second flexible circuit board |
| 21 | first flexible circuit board | 231 | supporting arm |
| 211 | sub flexible circuit board | 232 | comb-like conductor |
| 2111 | first sub flexible circuit board | 233 | first folding construction |
| 2112 | second sub flexible circuit board | 234 | second folding construction |
| 2113 | third sub flexible circuit board | 24 | electrical connector |
| 212 | folding portion | 241 | insulative housing |
| 213 | turning portion | 242 | conductive terminal |
| 2131 | third folding construction | 3 | connecting piece |
| 214 | folding close line | 41 | first adapting connector |
| | | 42 | second adapting connector |

### DETAILED DESCRIPTION

Now exemplary embodiments will be described more fully with reference to the accompanying drawings. However, the exemplary embodiments can be implemented in a variety of forms, and should not be construed as limited to the embodiments described herein; on the contrary, providing these embodiments makes the present disclosure comprehensive and complete, and makes the concept of exemplary embodiments fully conveyed to those skilled in the art. The same reference numerals in the figures represent the same or similar structures, and therefore repeated description thereof will be omitted.

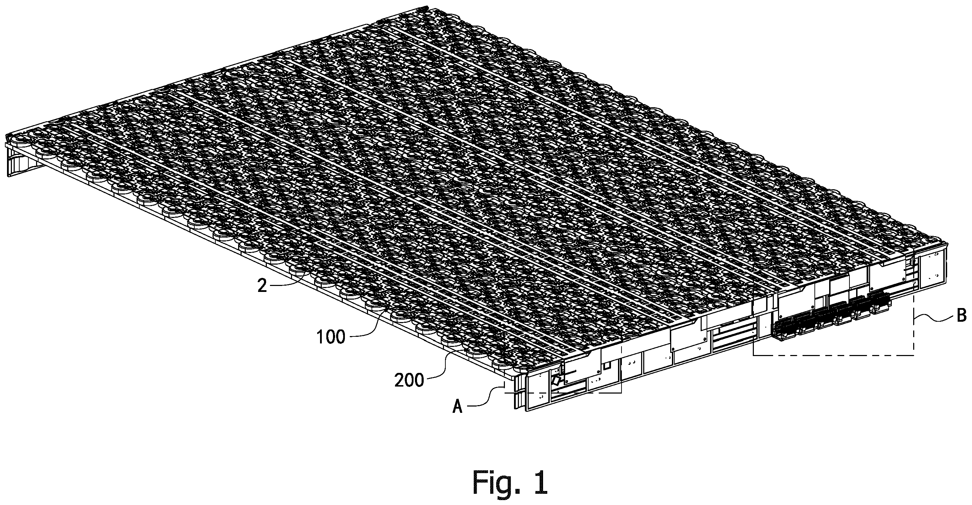

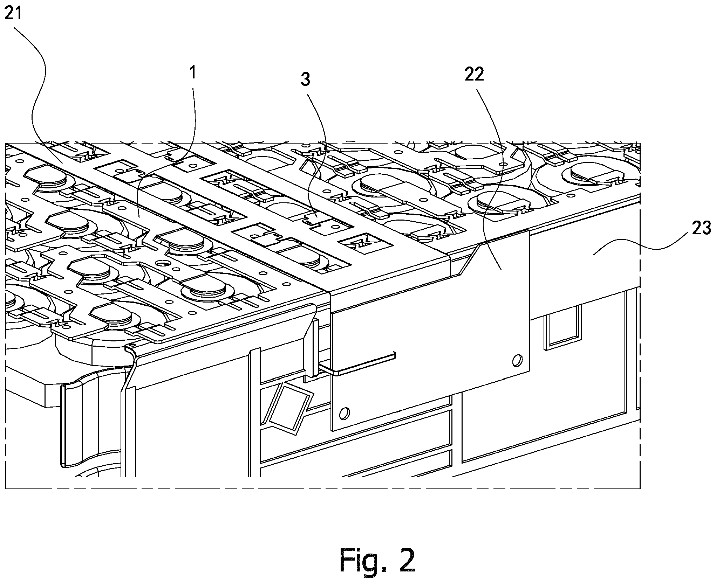

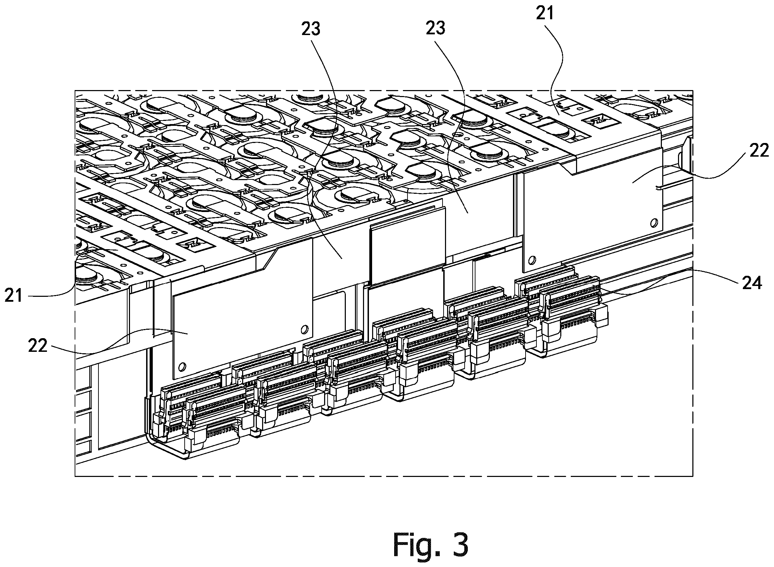

As shown in FIG. 1 to FIG. 3, FIG. 1 illustrates a schematic view of a battery connection module 100 of a first embodiment of the present disclosure mounted over a battery unit array 200, FIG. 2 illustrates a partially enlarged view indicated by a dotted line frame A of FIG. 1, and FIG. 3 illustrates a partially enlarged view indicated by a dotted line frame B of FIG. 1. A battery connection module 100 of a first embodiment of the present disclosure includes a plurality of busbars 1 and a plurality of sampling assemblies 2. The plurality of busbars 1 are used to connect a battery unit array 200. The plurality of sampling assemblies 2 electrically connect with the plurality of busbars 1, and are used to collect temperatures, voltages or other battery parameters of the battery unit array 200.

It may be understood that, the terms "includes (include/including)" and "has (have/having)" in the embodiments of the present disclosure and any variant thereof are intended to cover non-exclusive inclusion. For example, a process, method, system, product or device that includes a series of steps or units is not limited to the listed steps or units, but optionally also includes a step or unit that is not listed, or optionally also includes other step or component that is inherent to the process, method, product or device.

It is noted that, positive electrodes and negative electrodes of batteries of the battery unit array 200 all are positioned at a top surface of the battery unit array 200, the plurality of busbars 1 are used to connect the positive electrodes and the negative electrodes of the batteries. The sampling assembly 2 may electrically connect the corresponding busbar 1 by a connecting piece 3. Specifically, one end of the connecting piece 3 may connect a wiring of the sampling assembly 2 by welding, other end of the connecting piece 3 also may connect with the busbar 1 by welding.

Certainly, in other embodiments, the sampling assembly 2 also may directly connect busbar 1 by welding.

Each sampling assembly 2 includes a first flexible circuit board 21, an adapting circuit board 22 and a second flexible circuit board 23. The adapting circuit board 22 is used to adapt the first flexible circuit board 21 and the second flexible circuit board 23. The first flexible circuit board 21 connects the plurality of busbars 1. As mentioned previously, the first flexible circuit board 21 may be welded with the busbar 1 via the connecting piece 3, also the first flexible circuit board 21 may be directly welded with the busbar 1.

A rear end of the first flexible circuit board 21 includes a turning portion 213, the turning portion 213 is connected to the adapting circuit board 22 which is positioned in a plane different from a plane where the first flexible circuit board 21 is presented. Specifically, the turning portion 213 of the first flexible circuit board 21 and the adapting circuit board 22 both are positioned at a side surface of the battery unit array 200, and connect each other. The other part of the first flexible circuit board 21 except the turning portion 213 is positioned at the top surface of the battery unit array 200. The adapting circuit board 22 and the second flexible circuit board 23 connect each other, and both are provided at the side surface of the battery unit array 200.

That the first flexible circuit board 21 and the second flexible circuit board 23 are adapted by the adapting circuit board 22 may realize a layout of the first flexible circuit board 21 and the second flexible circuit board 23 in different planes, and that the first flexible circuit board 21 and the second flexible circuit board 23 may be each separately manufactured promotes utilization ratios of materials.

It may be understood that, the terms "rear end" and "front end" are defined that one end close to an electrical connector 24 is "rear end" and one end away from the electrical connector 24 is "front end".

A front end of the second flexible circuit board 23 is connected to the adapting circuit board 22, a rear end of the second flexible circuit board 23 includes at least one electrical connector 24. The electrical connector 24 is used to connect an external battery management system (not shown), the battery management system is used to detect temperatures, voltages or other battery parameters of the battery unit array 200.

The adapting circuit board 22 has a wire jumper construction, and a wiring arrangement definition of the first flexible circuit board 21 is different from a wiring arrangement definition of the second flexible circuit board 23. The first flexible circuit board 21 and the second flexible circuit board 23 each are a single layer wiring board, the adapting circuit board 22 is a double layer wiring board.

That the adapting circuit board 22 is designed as a double layer wiring board and has the wire jumper construction can realize different wiring arrangement definitions, that the first flexible circuit board 21 and the second flexible circuit board 23 each are a single layer board may greatly lower cost.

The adapting circuit board 22 is a rigid circuit board. That the first flexible circuit board 21 and the second flexible circuit board 23 each are a flexible circuit board is convenient to disassemble and assemble with the adapting circuit board 22, that the adapting circuit board 22 is a rigid circuit board may further lower cost.

In an embodiment, each first flexible circuit board 21 has the same construction, which is convenient to better utilize a material and may be greatly save cost of mold and jig.

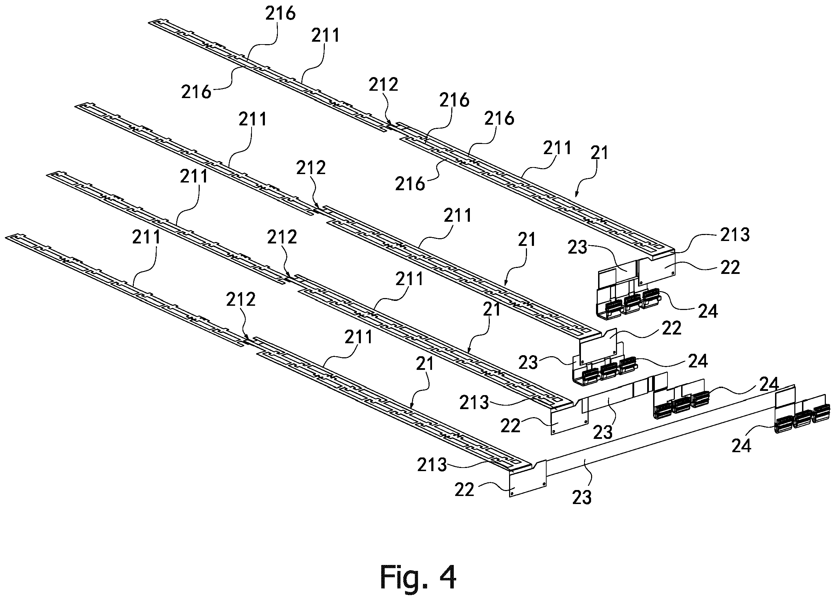

As shown in FIG. 1 and FIG. 4, FIG. 4 illustrates a schematic view the plurality of sampling assemblies 2 of FIG. 1 with the battery unit array 200 removed. Each second flexible circuit board 23 has a different length, the lengths of the plurality of second flexible circuit boards 23 are set so that the respective electrical connectors 24 of the rear ends of the respective second flexible circuit boards 23 are close each other to be compactly arranged.

In the present embodiment, the rear end of each second flexible circuit board 23 is provided with three electrical connectors 24, by that lengths of the plurality of second flexible circuit boards 23 are designed as different, it may make the three electrical connectors 24 of the each second flexible circuit board 23 close to be compactly arranged with the three electrical connectors 24 of other corresponding second flexible circuit board 23, the twelve electrical connectors 24 as shown in FIG. 1 are provided as two rows. Certainly, the arrangement of the plurality of electrical connectors 24 of the plurality of second flexible circuit boards 23 is not limited thereto.

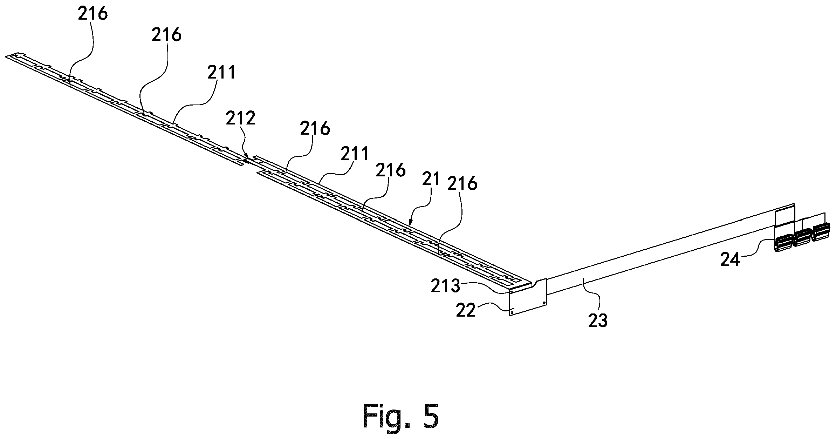

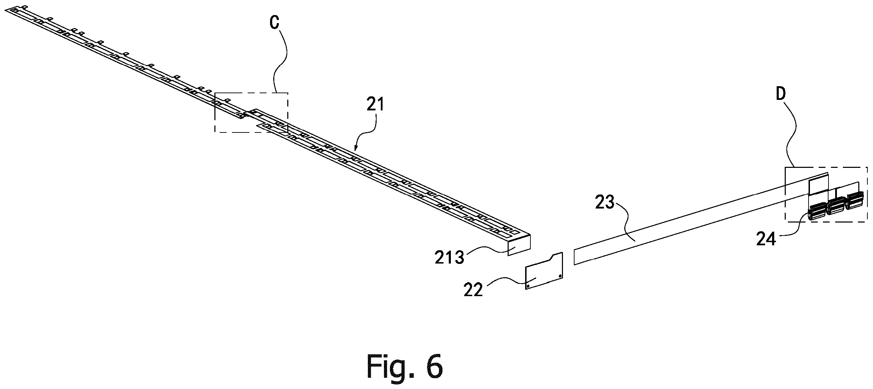

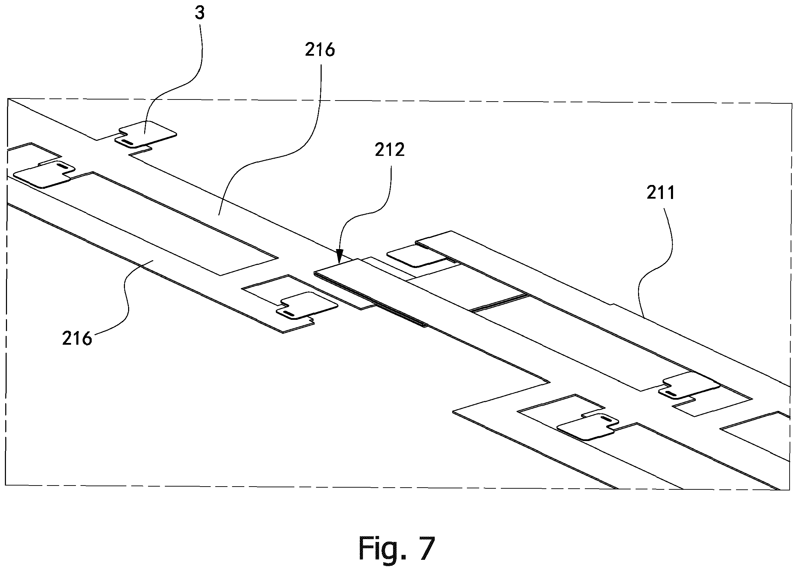

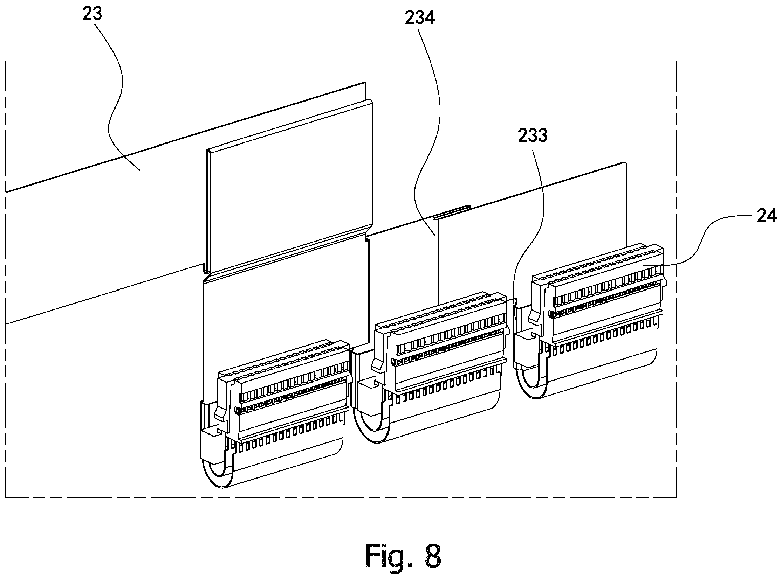

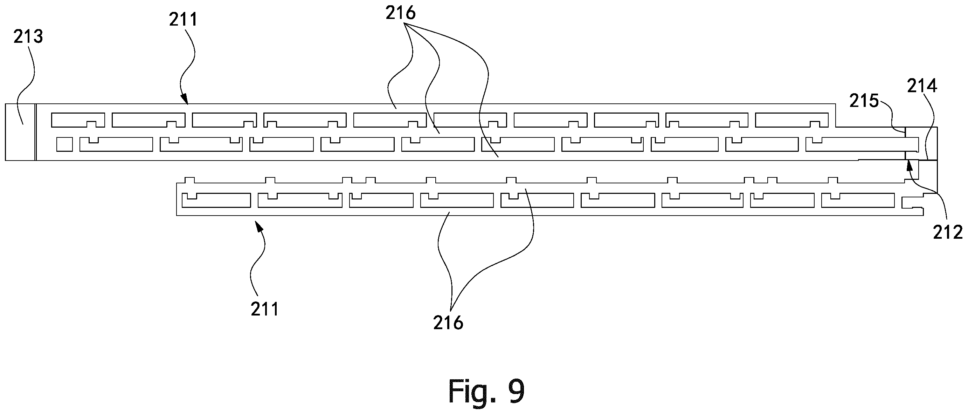

As shown in FIG. 5 to FIG. 9, FIG. 5 illustrates a schematic view of one of the plurality of sampling assemblies 2 of the first embodiment of the present disclosure, FIG. 6 illustrates an exploded schematic view of FIG. 5, FIG. 7 illustrates a partially enlarged view indicated by a dotted line frame C of FIG. 6, FIG. 8 illustrates a partially enlarged view indicated by a dotted line frame D of FIG. 6, and FIG. 9 illustrates a schematic view that the first flexible circuit board 21 of the present disclosure is not folded. The first flexible circuit board 21 includes at least two sub flexible circuit boards 211 which are integrally constructed and a folding portion/folding portions 212 which each connect end portions of respective sub flexible circuit boards 211, the first flexible circuit board 21 is constituted by folding the at least two sub flexible circuit boards 211.

As shown in FIG. 9, the first flexible circuit board 21 includes two sub flexible circuit boards 211, the two sub flexible circuit boards 211 are integrally constructed via a folding portion 212. The turning portion 213 is provided on a rear end of one of the two sub flexible circuit boards 211. Each folding portion212 includes a folding close line 214 and a folding away line 215, here the folding close line 214 extends along a length direction of the sub flexible circuit board 211, the folding away line 215 extends along a width direction of the sub flexible circuit board 211. Before folding is performed on the folding portion 212, the two sub flexible circuit boards 211 are parallel to each other and are provided to be arranged side by side along the width direction of the two sub flexible circuit boards 211. After folding along the folding close line 214, one sub flexible circuit board 211 is folded by 180 degrees relative to the other sub flexible circuit board 211 along the width direction, so that the two sub flexible circuit boards 211 form overlapped regions. Then folding is performed along the folding away line 215, the two sub flexible circuit boards 211 will be folded by 180 degrees along the length direction relative to each other, so that the two sub flexible circuit boards 211 form the first flexible circuit board 21 having an elongated structure (as shown in FIG. 5 and FIG. 6). Certainly, it also may be performed as that folding along the folding away line 215 is first performed and then folding along the folding close line 214 is performed.

In other embodiments, the folding portion 212 of the first flexible circuit board 21 also may only include the folding away line 215, when folding along the folding away line 215 is performed, one sub flexible circuit board 211 is folded by 180 degrees relative to the other sub flexible circuit board 211 along the length direction, which similarly also forms the first flexible circuit board 21 having an elongated structure, the two sub flexible circuit boards 211 are staggered with each other along the width direction.

The first flexible circuit board 21 is constituted by folding at least two sub flexible circuit boards 211, the at least two sub flexible circuit boards 211 are provided to be arranged side by side along the width direction before folding, so an entire length of the flexible circuit board is shorten, production difficulty is greatly lowered and utilization ratio of a material is promoted. After folding, the at least two sub flexible circuit boards 211 are sequentially provided along the length direction, a length of the flexible circuit board is increased, which meets the need for a long size circuit board.

Each sub flexible circuit board 211 includes at least one wiring track 216, from a front end of the first flexible circuit board 21 to the rear end of the first flexible circuit board 21, latter one sub flexible circuit board 211 is more than former one sub flexible circuit board 211 by one more wiring track 216. Because conductive traces gradually increase in number from the front end of the first flexible circuit board 21 toward the rear until extend to the rear end of the first flexible circuit board 21, that latter one sub flexible circuit board 211 is increased by one wiring track 216 relative to former one sub flexible circuit board 211 can accommodate more conductive traces to be arranged.

In the present embodiment, former one sub flexible circuit board 211 has two wiring tracks 216, and latter one sub flexible circuit board 211 has three wiring tracks 216.

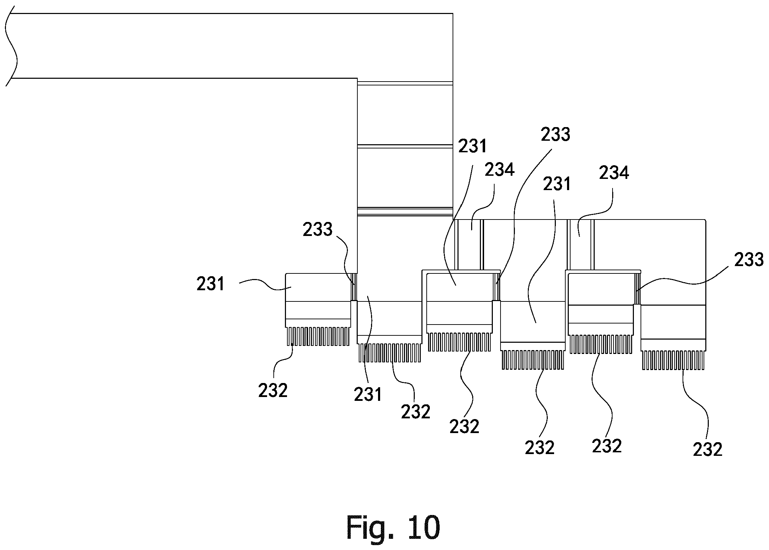

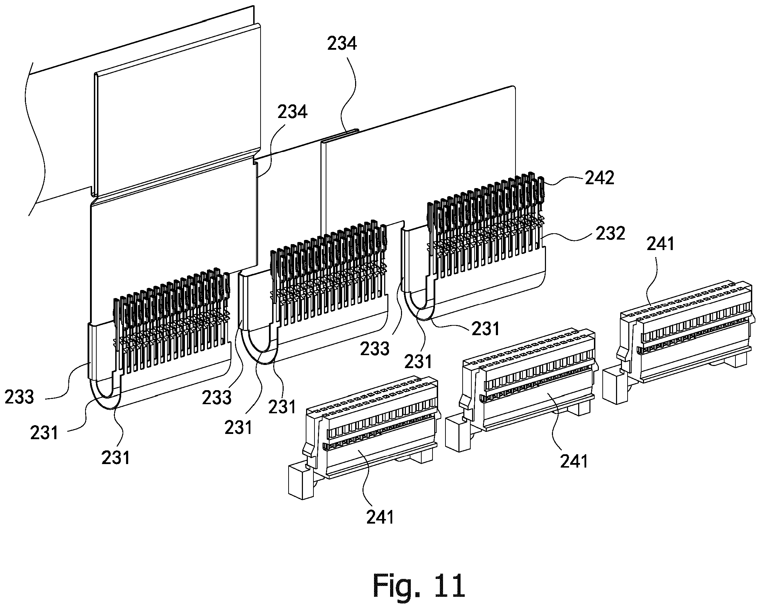

As shown in FIG. 10 and FIG. 11, FIG. 10 illustrates a schematic view that local parts of the second flexible circuit board 23 of the present disclosure are not folded, and FIG. 11 illustrates an exploded schematic view of FIG. 8. A rear end of the second flexible circuit board 23 is provided one or a plurality of supporting arms 231 which each are used to connect an corresponding electrical connector 24. A rear end of each supporting arm 231 has a comb-like conductor 232, the comb-like conductor 232 is used to electrically connect with the corresponding electrical connector 24. The electrical connector 24 includes an insulative housing 241 and a plurality of conductive terminals 242, the plurality of conductive terminals 242 are provided in the insulative housing 241. The comb-like conductor 232 are used to electrically connect with the corresponding conductive terminals 242.

The supporting arm 231 is plurality in number, and a plurality of supporting arms 231 are provided in pair. The two comb-like conductors 232 of the two supporting arms 231 provided in pair electrically connect with the same electrical connector 24. The two supporting arms 231 provided in pair are connected by a first folding construction 233 therebetween, by the first folding construction 233, the two supporting arms 231 may realize folding close to each other.

The two adjacent pairs of supporting arms 231 are connected by a second folding construction 234 therebetween, a distance between the two adjacent pairs of supporting arms 231 may be adjusted by the second folding construction 234, so that respective electrical connectors 24 at the rear end of the second flexible circuit board 23 are compactly arranged.

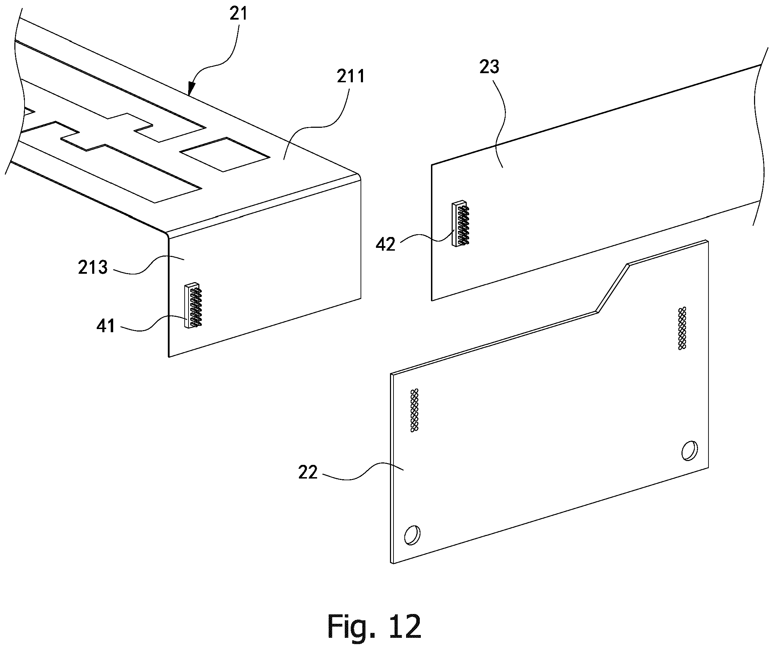

As shown in FIG. 12, FIG. 12 illustrates a partially exploded schematic view of a sampling assembly 2 of a second embodiment of the present disclosure. The features of the second embodiment which are the same as those of the first embodiment are not repeated herein, the second embodiment differs from the first embodiment as follows.

A rear end of the first flexible circuit board 21 has a first adapting connector 41, a front end of the second flexible circuit board 23 has a second adapting connector 42, the first flexible circuit board 21 is connected with the adapting circuit board 22 by the first adapting connector 41, the second flexible circuit board 23 is connected with the adapting circuit board 22 by the second adapting connector 42.

The first adapting connector 41 and/or the second adapting connector 42 may be connected with the adapting circuit board 22 by means of through-hole type welding. Certainly, a connection manner between the first adapting connector 41 and/or the second adapting connector 42 and the adapting circuit board 22 also may employ Surface Mounted Technology (SMT).

In an embodiment, the first adapting connector 41 is provided on the turning portion 213 of the first flexible circuit board 21.

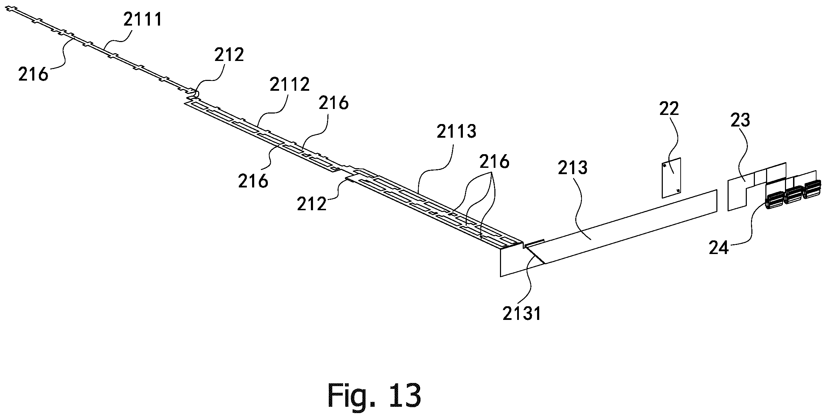

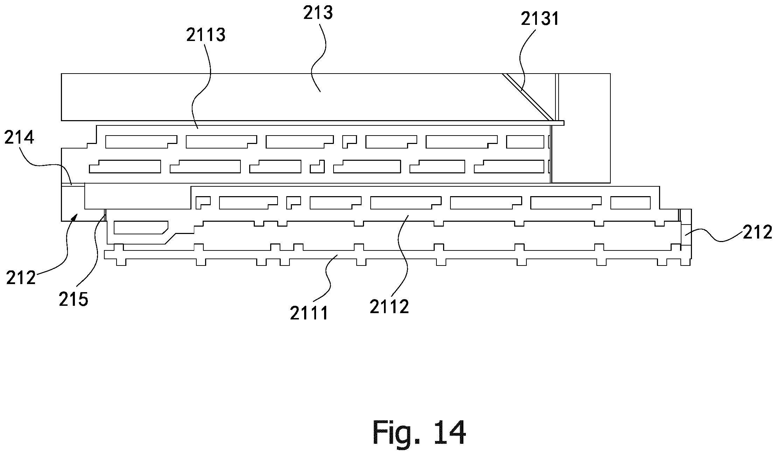

As shown in FIG. 13 and FIG. 14, FIG. 13 illustrates a schematic view of a sampling assembly 2 of a third embodiment of the present disclosure, and FIG. 14 illustrates a schematic view that the first flexible circuit board 21 of FIG. 13 is not folded. The features of the third embodiment which are the same as those of the first and second embodiments are not repeated herein, the second embodiment differs from the first and second embodiments as follows.

The first flexible circuit board 21 includes three sub flexible circuit boards 211, which respectively are a first sub flexible circuit board 2111, a second sub flexible circuit board 2112 and a third sub flexible circuit board 2113. A folding portion 212 is provided between an end portion of the first sub flexible circuit board 2111 and an end portion of the second sub flexible circuit board 2112, and a folding portion 212 is provided between an end portion of the second sub flexible circuit board 2112 and an end portion of the third sub flexible circuit board 2113.

Before folding, the first sub flexible circuit board 2111, the second sub flexible circuit board 2112 and the third sub flexible circuit board 2113 are provided to be arranged side by side along the width direction. After folding, the first sub flexible circuit board 2111, the second sub flexible circuit board 2112 and the third sub flexible circuit board 2113 are sequentially provided along the length direction and form an elongated structure.

The first sub flexible circuit board 2111 has one wiring track 216, the second sub flexible circuit board 2112 has two wiring tracks 216, and the third sub flexible circuit board 2113 has three wiring track 216.

The turning portion 213 is provided at an end portion of the third sub flexible circuit board 2113 which is away from the second sub flexible circuit board 2112. The turning portion 213 has a third folding construction 2131.

In conclusion, advantages and beneficial effects of the battery connection module 100 of the embodiments of the present disclosure lie in that: the first flexible circuit board 21 performs folding by means of a plurality of sub flexible circuit boards 211, a length of the first flexible circuit board 21 is increased in the process of folding away from each other, production difficulty may be greatly lowered and utilization ratio of a material is promoted. That the first flexible circuit board 21 and the second flexible circuit board 23 are adapted by the adapting circuit board 22 may realized a layout of the first flexible circuit board 21 and the second flexible circuit board 23 in different planes, and that the first flexible circuit board 21 and the second flexible circuit board 23 may be each separately manufactured promotes utilization ratios of materials. That the adapting circuit board 22 may be a double layer wiring board and provide wire jumper realizes different wiring arrangement definitions, that the flexible circuit boards 21,23 at two sides of the adapting circuit board 22 each may realize a single layer board greatly lowers cost. By the adapting circuit board 22, a plurality of first flexible circuit boards 21 may have the same construction, which is convenient to better utilize a material and may be greatly save mold and jig cost; by the adapting circuit board 22, a plurality of second flexible circuit boards 23 can utilize different length changes to make respective electrical connectors 24 at rear ends of respective second flexible circuit boards 23 can be close to be compactly arranged.

It may be understood that the embodiments/implementing manners provided by the present disclosure may be combined with each other without contradiction, which will not be described in detail herein.

In the embodiments of the present disclosure, the terms "first", "second" and "third" are only used for the purpose of description and cannot be understood as indicating or implying relative importance; the term "plurality of" refers to two or more, unless otherwise expressly defined. The terms "mount, "connect with", "connect", "fix" and other likes should be understood in a broad sense. For example, "connect" maybe fixedly connect, detachably connect, or integrally connect; "connect with" may be directly connect with or indirectly connect with via an intermediate media. For ordinary technicians in the art, the specific meaning of the above terms in the embodiments of the present disclosure may be understood according to specific situations.

In the description of the embodiments of the present disclosure, it should be understood that the terms "up", "down", "left", "right", "front", "rear" and the like indicating the orientation or position relationship are based on the orientation or position relationship shown in the figure, are only for the convenience of describing the embodiments of the present disclosure and simplifying the description, rather than for indicating or implying that the device or unit referred to must have a specific direction, be constructed and operated in a specific orientation. Therefore, these terms cannot be understood as a limitation on the embodiments of the present disclosure.

In the description of this specification, the description of the terms "one embodiment", "some embodiments", "specific embodiments" and the like means that the specific features, structures, materials or characteristics described in combination with this embodiment or example are included in at least one embodiment or example of the embodiments of the present disclosure. In this specification, the schematic expressions of the above terms do not necessarily refer to the same embodiments or examples. Moreover, the specific features, structures, materials or characteristics described may be combined in an appropriate manner in any one or more embodiments or examples.

The above is only the preferred embodiment of the embodiments of the present disclosure, and is not used to limit the embodiments of the present disclosure. For those skilled in the art, the embodiments of the present disclosure can have various modifications and changes. Any modification made within the principles of the embodiments of the present disclosure shall be included in the protection scope of the embodiments of the present inventions as defined in the appended claims.

## Claims

1. A battery connection module (100) used to connect a battery unit array (200), the battery connection module (100) comprising:
a plurality of busbars (1) used to connect the battery unit array (200);
a plurality of sampling assemblies (2), each sampling assembly (2) comprising a first flexible circuit board (21), an adapting circuit board (22) and a second flexible circuit board (23), the first flexible circuit board (21) connecting the plurality of busbars (1), the first flexible circuit board (21) being constituted by folding at least two sub flexible circuit boards (211), a rear end of the first flexible circuit board (21) comprising a turning portion (213), the turning portion (213) being connected to the adapting circuit board (22) which is positioned in a plane different from a plane where the first flexible circuit board (21) is presented, a front end of the second flexible circuit board (23) being connected to the adapting circuit board (22), a rear end of the second flexible circuit board (23) comprising at least one electrical connector (24),
wherein the adapting circuit board (22) has a wire jumper construction.

2. The battery connection module according to claim 1, wherein a wiring arrangement definition of the first flexible circuit board (21) is different from a wiring arrangement definition of the second flexible circuit board (23).

3. The battery connection module according to any one of the preceding claims, wherein the first flexible circuit board (21) and the second flexible circuit board (23) each are a single layer wiring board.

4. The battery connection module according to any one of the preceding claims, wherein the adapting circuit board (22) is a double layer wiring board.

5. The battery connection module according to any one of the preceding claims, wherein the adapting circuit board (22) is a rigid circuit board.

6. The battery connection module according to any one of the preceding claims, wherein each first flexible circuit board (21) has the same construction.

7. The battery connection module according to any one of the preceding claims, wherein each second flexible circuit board (22) has a different length.

8. The battery connection module according to any one of the preceding claims, wherein the lengths of the plurality of second flexible circuit boards (23) are set so that the respective electrical connectors (24) of the rear ends of the respective second flexible circuit boards (23) are close to be compactly arranged.

9. The battery connection module according to any one of the preceding claims, wherein the first flexible circuit board (21) comprises the at least two sub flexible circuit boards (211) which are integrally constructed and a folding portion/folding portions (212) which each connect end portions of respective sub flexible circuit board (211).

10. The battery connection module according to claim 9, wherein each folding portion (212) comprises a folding close line (214) and a folding away line (215).

11. The battery connection module according to any one of the preceding claims, wherein each sub flexible circuit board (211) comprises at least one wiring track (216) from a front end of the first flexible circuit board (21) to the rear end of the first flexible circuit board (21), latter one the sub flexible circuit board (211) is more than former one the sub flexible circuit board (211) by one wiring track (216).

12. The battery connection module according to any one of the preceding claims, wherein the first flexible circuit board (21) is provided at a top surface of the battery unit array (200), the adapting circuit board (22) and the second flexible circuit board (23) are provided at a side surface of the battery unit array (200).

## Patentansprüche

1. Batterieverbindungsmodul (100), das verwendet wird, um eine Batterieeinheitanordnung (200) zu verbinden, wobei das Batterieverbindungsmodul (100) umfasst:
eine Vielzahl von Sammelschienen (1), die verwendet wird, um die Batterieeinheitanordnung (200) zu verbinden;
eine Vielzahl von Probenahmeanordnungen (2), wobei jede Probenahmeanordnung (2) eine erste flexible Leiterplatte (21), eine anpassende Leiterplatte (22) und eine zweite flexible Leiterplatte (23) umfasst, wobei die erste flexible Leiterplatte (21) die Vielzahl von Sammelschienen (1) verbindet, wobei die erste flexible Leiterplatte (21) durch Falten von mindestens zwei flexiblen Unterleiterplatten (211) gebildet wird, wobei ein hinteres Ende der ersten flexiblen Leiterplatte (21) einen Wendeabschnitt (213) umfasst, wobei der Wendeabschnitt (213) mit der anpassenden Leiterplatte (22) verbunden ist, die in einer Ebene positioniert ist, die sich von einer Ebene unterscheidet, in der die erste flexible Leiterplatte (21) gezeigt ist, wobei ein vorderes Ende der zweiten flexiblen Leiterplatte (23) mit der anpassenden Leiterplatte (22) verbunden ist, wobei ein hinteres Ende der zweiten flexiblen Leiterplatte (23) mindestens einen elektrischen Verbinder (24) umfasst,
wobei die anpassende Leiterplatte (22) einen Drahtbrückenaufbau aufweist.

2. Batterieverbindungsmodul nach Anspruch 1, wobei eine Definition der Verdrahtungsanordnung der ersten flexiblen Leiterplatte (21) von einer Definition der Verdrahtungsanordnung der zweiten flexiblen Leiterplatte (23) verschieden ist.

3. Batterieverbindungsmodul nach einem der vorstehenden Ansprüche, wobei die erste flexible Leiterplatte (21) und die zweite flexible Leiterplatte (23) jeweils eine einlagige Verdrahtungsplatte sind.

4. Batterieverbindungsmodul nach einem der vorstehenden Ansprüche, wobei die anpassende Leiterplatte (22) eine doppellagige Verdrahtungsplatte ist.

5. Batterieverbindungsmodul nach einem der vorstehenden Ansprüche, wobei die anpassende Leiterplatte (22) eine starre Leiterplatte ist.

6. Batterieverbindungsmodul nach einem der vorstehenden Ansprüche, wobei jede erste flexible Leiterplatte (21) den gleichen Aufbau aufweist.

7. Batterieverbindungsmodul nach einem der vorstehenden Ansprüche, wobei jede zweite flexible Leiterplatte (22) eine unterschiedliche Länge aufweist.

8. Batterieverbindungsmodul nach einem der vorstehenden Ansprüche, wobei die Längen der Vielzahl von zweiten flexiblen Leiterplatten (23) so eingestellt sind, dass die jeweiligen elektrischen Verbinder (24) der hinteren Enden der jeweiligen zweiten flexiblen Leiterplatten (23) nahe beieinander liegen, um kompakt angeordnet zu sein.

9. Batterieverbindungsmodul nach einem der vorstehenden Ansprüche, wobei die erste flexible Leiterplatte (21) die mindestens zwei flexiblen Unterleiterplatten (211), die einstückig aufgebaut sind, und einen Faltabschnitt/Faltabschnitte (212) umfasst, die jeweils Endabschnitte der jeweiligen flexiblen Unterleiterplatte (211) verbinden.

10. Batterieverbindungsmodul nach Anspruch 9, wobei jeder Faltabschnitt (212) eine Faltschließlinie (214) und eine Wegfaltlinie (215) umfasst.

11. Batterieverbindungsmodul nach einem der vorstehenden Ansprüche, wobei jede flexible Unterleiterplatte (211) mindestens eine Verdrahtungsspur (216) von einem vorderen Ende der ersten flexiblen Leiterplatte (21) zum hinteren Ende der ersten flexiblen Leiterplatte (21) umfasst, wobei die letztgenannte flexible Unterleiterplatte (211) um eine Verdrahtungsspur (216) größer ist als die erstgenannte flexible Unterleiterplatte (211).

12. Batterieverbindungsmodul nach einem der vorstehenden Ansprüche, wobei die erste flexible Leiterplatte (21) an einer oberen Fläche der Batterieeinheitanordnung (200) bereitgestellt ist, die anpassende Leiterplatte (22) und die zweite flexible Leiterplatte (23) an einer Seitenfläche der Batterieeinheitanordnung (200) bereitgestellt sind.

## Revendications

1. Module de connexion de batterie (100) utilisé pour connecter un réseau d'unités de batterie (200), le module de connexion de batterie (100) comprenant :
une pluralité de barres omnibus (1) utilisées pour connecter le réseau d'unités de batterie (200) ;
une pluralité d'ensembles d'échantillonnage (2), chaque ensemble d'échantillonnage (2) comprenant une première carte de circuit imprimé flexible (21), une carte de circuit imprimé d'adaptation (22) et une seconde carte de circuit imprimé flexible (23), la première carte de circuit imprimé flexible (21) reliant la pluralité de barres omnibus (1), la première carte de circuit imprimé flexible (21) étant constituée en pliant au moins deux sous-cartes de circuit imprimé flexibles (211), une extrémité arrière de la première carte de circuit imprimé flexible (21) comprenant une partie tournante (213), la partie tournante (213) étant connectée à la carte de circuit imprimé d'adaptation (22) qui est positionnée dans un plan différent d'un plan où la première carte de circuit imprimé flexible (21) est présentée, une extrémité avant de la seconde carte de circuit imprimé flexible (23) étant connectée à la carte de circuit imprimé d'adaptation (22), une extrémité arrière de la seconde carte de circuit imprimé flexible (23) comprenant au moins un connecteur électrique (24),
dans lequel la carte de circuit imprimé d'adaptation (22) présente une structure de cavaliers.

2. Module de connexion de batterie selon la revendication 1, dans lequel une définition d'agencement de câblage de la première carte de circuit imprimé flexible (21) est différente d'une définition d'agencement de câblage de la seconde carte de circuit imprimé flexible (23).

3. Module de connexion de batterie selon l'une quelconque des revendications précédentes, dans lequel la première carte de circuit imprimé flexible (21) et la seconde carte de circuit imprimé flexible (23) sont chacune une carte de câblage à simple couche.

4. Module de connexion de batterie selon l'une quelconque des revendications précédentes, dans lequel la carte de circuit imprimé d'adaptation (22) est une carte de câblage à double couche.

5. Module de connexion de batterie selon l'une quelconque des revendications précédentes, dans lequel la carte de circuit d'adaptation (22) est une carte de circuit rigide.

6. Module de connexion de batterie selon l'une quelconque des revendications précédentes, dans lequel chaque première carte de circuit imprimé flexible (21) présente la même structure.

7. Module de connexion de batterie selon l'une quelconque des revendications précédentes, dans lequel chaque seconde carte de circuit imprimé flexible (22) présente une longueur différente.

8. Module de connexion de batterie selon l'une quelconque des revendications précédentes, dans lequel les longueurs de la pluralité de secondes cartes de circuit imprimé flexibles (23) sont définies de sorte que les connecteurs électriques respectifs (24) des extrémités arrière des secondes cartes de circuit imprimé flexibles respectives (23) sont proches de manière à être disposés de manière compacte.

9. Module de connexion de batterie selon l'une quelconque des revendications précédentes, dans lequel la première carte de circuit imprimé flexible (21) comprend les au moins deux sous-cartes de circuit imprimé flexibles (211) qui sont construites d'un seul tenant et une partie pliable/des parties pliables (212) qui relient chacune des parties d'extrémité de la sous-carte de circuit imprimé flexible respective (211).

10. Module de connexion de batterie selon la revendication 9, dans lequel chaque partie pliable (212) comprend une ligne de pliage proche (214) et une ligne de pliage distante (215).

11. Module de connexion de batterie selon l'une quelconque des revendications précédentes, dans lequel chaque sous-carte de circuit imprimé flexible (211) comprend au moins une piste de câblage (216) allant d'une extrémité avant de la première carte de circuit imprimé flexible (21) jusqu'à l'extrémité arrière de la première carte de circuit imprimé flexible (21), la sous-carte de circuit imprimé flexible suivante (211) comptant une piste de câblage (216) en plus que la sous-carte de circuit imprimé flexible précédente (211).

12. Module de connexion de batterie selon l'une quelconque des revendications précédentes, dans lequel la première carte de circuit imprimé flexible (21) est disposée sur une surface supérieure du réseau d'unités de batterie (200), la carte de circuit imprimé d'adaptation (22) et la seconde carte de circuit imprimé flexible (23) sont disposées sur une surface latérale du réseau d'unités de batterie (200).
